# EUROPEAN PATENT SPECIFICATION

(11) **EP 3 389 283 B1**
(45) Date of publication and mention of the grant of the patent: **18.08.2021**
(21) Application number: 17166473.3
(22) Date of filing: 13.04.2017
(51) Int. Cl.: H04Q 1/02, H05K 7/14

(54) **TEST DEVICE CARRIER RACK**
TRÄGERGESTELL FÜR TESTVORRICHTUNG
SUPPORT PORTEUR DE DISPOSITIF DE TEST

(43) Date of publication of application: 17.10.2018
(73) Proprietor: Rohde & Schwarz GmbH & Co. KG, 81671 München (DE)
(72) Inventor: MEHRGARDT, Philip, 4528 Zuchwil (CH)
(74) Representative: Isarpatent

(56) References cited:
- US-A1- 2005 257 232
- US-A1- 2006 220 505

## Description

### TECHNICAL FIELD

The present invention relates to a test device carrier rack.

### BACKGROUND

Although applicable in principal to any measurement system, the present invention and its underlying problem will be hereinafter described in combination with measurements of the coverage and signal quality of wireless networks.

The development of modern communication systems requires intensive evaluation and measurement of the single elements of the communication systems. In modern wireless communication systems it is for example not only necessary to evaluate the single end user devices. It is e.g. also necessary to evaluate the coverage and signal quality provided by the communication system infrastructure.

Such measurements of the coverage and signal quality are usually performed by moving receiving devices of the respective communication system in the area of interest and evaluating the signals received by such devices.

Moving around receiving devices may be a cumbersome task, especially in large and/or crowded areas, like e.g. cities. Usually the measurement devices are therefore installed in a vehicle. However, it is a difficult task to move the measurement devices from one vehicle to another.

Against this background, the problem addressed by the present invention is to allow more flexible measurements of communication system infrastructure. An example of such a system infrastructure is disclosed by the document US2006/220505, Nakamura Akio, published on 5 October 2006.

### SUMMARY

The present invention solves this object by a test device carrier rack with the features of claim 1.

Accordingly it is provided:
- A test device carrier rack for carrying test devices, the test device carrier rack comprising a rack frame, the rack frame comprising a number of stands, i.e. one or more, and a number, i.e. one or more, of device carrier beams that are coupled to the stand, and a number, i.e. one or more, of test device fixtures movably arranged on the device carrier beams configured to carry the test devices.

The present invention is based on the knowledge that tests of wireless network infrastructure may be performed with a plurality of test devices that are usually difficult to install and arrange e.g. in a vehicle.

The present invention therefore provides a universal carrier rack for test devices. The stands allow flexibly mounting and fixing the test device carrier rack in different mounting spaces, like e.g. a vehicle or an office or laboratory.

At the same time the test device carrier rack provides the carrier beams that are coupled to the stands. While the stands provide the secure fixation of the test device carrier rack, the carrier beams provide a versatile holding means for the test device fixtures that are movably attached to the device carrier beams.

This means that single test devices may flexibly be positioned on the single carrier beams such that the test devices are positioned in the ideal test and measurement position.

The test devices may e.g. be any kind of receiver or measurement probe that may receive the signals from the infrastructure of the communication system that has to be evaluated. Such test devices may therefore comprise e.g. smartphones, standard handsets, data devices like USB modem sticks, RF scanners, WIFI adaptors or the like. It is also possible that smartphones with a test firmware or especially adapted software are used as test devices. Test firmware or especially adapted software in this regard refers to a firmware or software that comprises special measurement functions that are not provided in the standard firmware/software. It is understood, that other test devices like compute modules, control modules, RF scanners or the like may also be used with the test device carrier rack.

Especially in the case that smartphones, standard handsets, or data devices are used as measurement probes but not limited to these examples, the tests may be performed with the internal antennas of the mobile devices. Since the tests should be comparable the measurement probes should be positioned such that the RF reception characteristics of the measurement probes are as similar as possible.

This may e.g. be achieved with the test device carrier rack of the present invention because the position of the test devices, i.e. the measurement probes, may be flexibly adapted. In a vehicle the test devices may e.g. all be positioned at a window of the vehicle that provides an opening in the faraday cage that the vehicle shell forms. For example the test device carrier rack may be positioned inside of the vehicle right in front of a window or at a predetermined distance from the window. Even if the test device carrier rack may be broader than the window, the single test devices may then be positioned at the window opening by moving the movable test device fixtures to the respective positions.

Therefore, with the test device carrier rack of the present invention the user receives a modular and easily adjustable test rack for a plurality of test devices.

Further embodiments of the present invention are subject of the further subclaims and of the following description, referring to the drawings.

In a possible embodiment, the stand may comprise at least one lower leg with a bottom base attached the lower leg. In addition or as an alternative the stand may comprise at least one upper leg with a top base attached to the upper leg.

The bases may e.g. be board-like or plate-like arrangements, corner bracket arrangements or the like. Further the bases may comprise wheels, especially wheels with brakes that allow flexibly positioning the test device carrier rack and then fixing the test device carrier rack in its final position.

With the help of the bases the test device carrier rack may be securely positioned e.g. inside of a vehicle, like a van.

At the same time the bases will serve to securely hold the test device carrier rack if the test device carrier rack is used statically, e.g. in a laboratory or office.

In a possible embodiment, the at least one lower leg and/or the at least on upper leg may be vertically extendable.

Vertically extendable legs provide for an easy adjustment of the overall height of the test device carrier rack. This allows easily switching the test device carrier rack e.g. from the trunk of a station wagon to a van by simply extending the legs as required to spread and fix the test device carrier rack between the roof and the ground or bottom of the vehicle.

In a possible embodiment, the device carrier beams may be horizontally extendable. This allows adjusting the width of the test device carrier rack easily.

In a possible embodiment, the device carrier beams may be horizontally arranged on the rack frame. In addition or as alternative the device carrier beams may be attached vertically slidable to the rack frame. In addition or as alternative the test device fixtures may each be attached to the device carrier beams via a slidable and/or releasable fixture.

The device carrier beams may be horizontally arranged on vertically arranged legs or a middle section extending from the legs of the rack frame. For example an arrangement of lower leg, middle section and upper leg may be provided on both ends of the device carrier beams. The carrier beams may e.g. comprise releasable clamps that allow vertically sliding the device carrier beams on the legs or the middle section.

Slidably attached device carrier beams may therefore easily be positioned in height as required. This may e.g. be especially useful to adapt the position of the test devices inside of a vehicle. For example in a van the window opening may extend from about the center of a side wall to under the roof. The height of the device carrier beams may therefore be adjusted such that the device carrier beams that carry measurement probes are positioned in front of the window. Further, one or more of the device carrier beams that carry e.g. computing and control modules may be positioned below the window, while leaving enough space in front of the window for the measurement probes or devices.

In a possible embodiment, the rack frame may comprise at least one tiltable hinge that allows tilting at least part of the rack frame in a vertical axis.

The tiltable rack frame provides a further degree of freedom with every tiltable hinge and therefore provides even more flexibility when adapting the rack frame to a mounting space.

With the mechanical flexibility of the test device carrier rack test devices may easily and quickly be mounted in different mounting spaces, like different vehicles. The single vehicle customization effort is therefore greatly reduced.

In a possible embodiment, the rack frame and/or the test device fixtures may comprise a RF transparent material and/or an optically transparent material.

RF transparent materials may e.g. comprise plastic or any other synthetic material, glass or the like. If such materials are used as building materials for the rack frame and/or the test device fixtures, the measurements that are performed with the test devices are not influenced by the elements of the test device carrier rack and the overall measurement quality is improved.

The same applies to optically transparent materials, like e.g. acrylic glass or the like, if optical communication systems are evaluated. If for example a visible light communication system is evaluated acrylic glass elements will not obstruct the paths that the visible light travels.

It is understood, that only some elements of the test device carrier rack, like e.g. the device carrier beams or the stand, may be made of or comprise such RF transparent or optically transparent materials.

In a possible embodiment, the stand may comprise installation means, wherein the installation means may comprise suction cups and/or hooks and/or mounting holes and/or mounting plates.

The installation means may in addition to spreading the test device carrier rack into the vehicle serve to further fix the test device carrier rack e.g. in a vehicle. The suction cups may be attached to smooth and flat surfaces, like the windows or other surfaces in a vehicle. The hooks may serve to fix the test device carrier rack to the window glass, e.g. by fitting the hooks over the window glass and closing the window. The mounting holes may serve to fix the test device carrier rack to any other fixation means that may already be present in the vehicle. Finally, the mounting plates may serve to attach the test device carrier rack to any other element in the vehicle e.g. via adhesive strips or the like.

In a possible embodiment, the test device carrier rack may comprise optical hiding devices.

The optical hiding devices may e.g. be covers, enclosures or masks that may be attached to the rack frame and optically cover the test device fixtures and the test devices. The optical hiding devices therefore provide an anti-theft protection for the test device carrier rack, since they disguise the test device carrier rack. It is understood, that the optical hiding devices may e.g. have an unobtrusive or inconspicuous design on the side that is visible from outside of a vehicle.

The optical hiding devices may e.g. simply be put over the test device carrier rack like a coat or may be attached via magnets, clamps or the like.

In a possible embodiment, the test device carrier rack may comprise coupling devices for coupling the test device carrier rack with other test device carrier racks.

The coupling devices may be any type of mechanical coupling devices like e.g. holes and screws, clamps, bar clamps, quick release clamps or the like.

The coupling devices may be arranged on any side of the test device carrier rack. Therefore, with the coupling devices the test device carrier rack may be stacked horizontally or vertically to provide combined larger test device carrier racks that can carry an increased number of test devices.

In a possible embodiment, at least one test device fixture may comprise a device cover with configurable attenuation.

The covers of the device fixtures may e.g. be formed such that the test device is accommodated in a device recess inside of the cover. The configurable attenuation may e.g. be configured with exchangeable attenuation plates, e.g. plates of absorbing foam that may be arranged in or on the cover.

The covers may comprise passive or active cooling means for the test devices. Such cooling means may e.g. be cooling openings for passive cooling of the test device inside of the cover. As an alternative the cover may comprise active cooling elements, like e.g. fans.

It is understood that active cooling elements, like fans, may also be provided on the rack frame.

In a possible embodiment, at least one of the test device fixtures may comprise a spring loaded clamping mechanism to clamp one of the test devices.

In a possible embodiment, at least one of the test device fixtures comprises a belt, especially a hook-and-pile or Velcro fastener belt, for securing one of the test devices.

The spring loaded clamping device may e.g. comprise two arms that may be pulled apart when installing a test device. The spring will then pull the arms together when they are released. The hook-and-pile fastener belt may be used as an alternative or in addition to the spring loaded clamping mechanism.

With the spring loaded clamping mechanism and the belt test devices of any size and form may be fixed in the test device fixtures and no device specific holder, e.g. a phone holder, is necessary.

In a possible embodiment, the test device carrier rack may comprise an integrated cable harness for contacting the test devices in the test device fixtures.

The cable harness may e.g. provide a cable connection to every one of the test device fixtures and therefore to every single test device. The cable harness may e.g. bring together all cables at a single point or a single area, like e.g. one of the device carrier beams. Therefore, the test devices may be attached with only few additional cables. The single point or area may especially comprise a fixture for a compute or control module that carries such a compute or control module. The wire harness may therefore serve to communicatively couple the compute or control module with the single test devices.

The single cables may e.g. comprise retractable cables with spring loaded cable drums. This allows providing the cable harness to the test device fixtures and at the same time keeping the flexible mounting options.

Further, the cable harness may also at least in part comprise bus bars that may be integrated into the structure of the rack frame and the device carrier beams. The bus bars may comprise receptacles or connectors to contact cables or device fuxtures.

The cable harness may be used to provide electrical energy to the test devices and/or to communicate data to/from the test devices. If for example smartphones are used as measurement probes, the cable harness may comprise a USB cable, like USB 2, USB 3 or USB Type C, and/or an audio cable to connect every single smartphone in the respective test device fixture. Any other type of cables is also possible.

It is understood, that the test device fixtures may not only carry measurement probes like e.g. smartphones or the like. In addition the test device fixtures may also carry computing and evaluation modules that may receive data and/or signals from the measurement probes and perform signal evaluation or storage for later evaluation. In addition dedicated fixtures may be provided for such other devices on the device carrier beams.

Other test devices that may be carried by the test device fixtures or dedicated fixtures may e.g. be RF scanners, NCM2 modules and the like. It is further understood, that the cable harness may also provide dedicated bus communication lines e.g. for a BM11 or BM11 GO data bus, that may be used to communicate with the test devices

If these other types of test devices, like e.g. the RF scanner, fit into the test device fixtures, they can easily be installed at the same positions as the measurement probe test devices.

If the test device carrier rack comprises the coupling devices for coupling the test device carrier rack with other test device carrier racks, these coupling devices may also comprise connectors and/or bus bars that allow easily coupling the test device carrier racks electronically.

Further, the single test device carrier racks may comprise data line multiplexers and demultiplexers that may multiplex and de-multiplex the data and communication lines of the cable harness at the connection point between two test device carrier racks. This greatly simplifies the electrical interconnection of two test device carrier racks because a greatly reduced number of connections is sufficient to interconnect two test device carrier racks. In a possible embodiment, the test device carrier rack may comprise a power supply device for supplying the test devices with electrical energy.

The power supply device may e.g. comprise a mains adaptor for a 230 V or 110 V power outlet or an adaptor for a 12 V vehicle power outlet, e.g. a cigarette lighter outlet. Any other type of adaptor is also possible.

With the power supply it is possible to provide the test devices with electrical energy without the risk of depleting internal batteries of the test devices. Therefore an increased operational time may be achieved for the test arrangement.

In a possible embodiment, the power supply device may comprise at least one energy storage device.

With the energy storage device it is possible to autonomously (energy-wise) operate the test devices in the test device carrier rack. Therefore no energy will be drained from e.g. a vehicle power supply. This is especially useful if the test device carrier rack is used e.g. on an electric vehicle that comprises no combustion engine.

In a possible embodiment, the power supply device may comprise at least one battery emulator that is configured to emulate the battery of a number of test devices and supply the respective test devices with electrical energy.

The battery emulator may e.g. comprise adaptors to replace the batteries of the test devices. This allows running test devices without external power supply connector or that may not be charged and operate at the same time via the power supply device while operating the test arrangement on the test device carrier rack.

In a possible embodiment, the test device carrier rack may comprise a control module and/or a compute module. The control module and/or compute module may be an integrated control module and/or compute module that forms an integrated test and control arrangement with the test device carrier rack. Integrated in this regard may refer to the test device carrier rack and the control module and/or compute module forming a functional unit. This means that the control module and/or compute module may be integrated, i.e. fixed, to the test device carrier rack. This may however also mean that the control module and/or compute module may be couplet to the test device carrier rack, e.g. the cable harness of the test device carrier rack, via a dedicated connection that carries all necessary data and power lines. This allows e.g. providing the integrated control module and/or compute module in a vehicle near the test device carrier rack.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
- Fig. 1: shows a schematic view of an embodiment of a test device carrier rack according to the present invention;
- Fig. 2: shows a schematic view of another embodiment of a test device carrier rack according to the present invention;
- Fig. 3: shows a schematic view of another embodiment of a test device carrier rack according to the present invention;
- Fig. 4: shows a schematic view of an embodiment of an extendable beam;
- Fig. 5: shows a cross sectional view of the extendable beam of Fig. 4;
- Fig. 6: shows a schematic view of another embodiment of an extendable beam;
- Fig. 7: shows a schematic view of an embodiment of coupled test device carrier racks according to the present invention; and
- Fig. 8: shows a schematic view of another embodiment of a test device carrier rack according to the present invention.

The appended drawings are intended to provide further under-standing of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown to scale.

In the drawings, like, functionally equivalent and identically operating elements, features and components are provided with like reference signs in each case, unless stated otherwise.

### DETAILED DESCRIPTION OF THE DRAWINGS

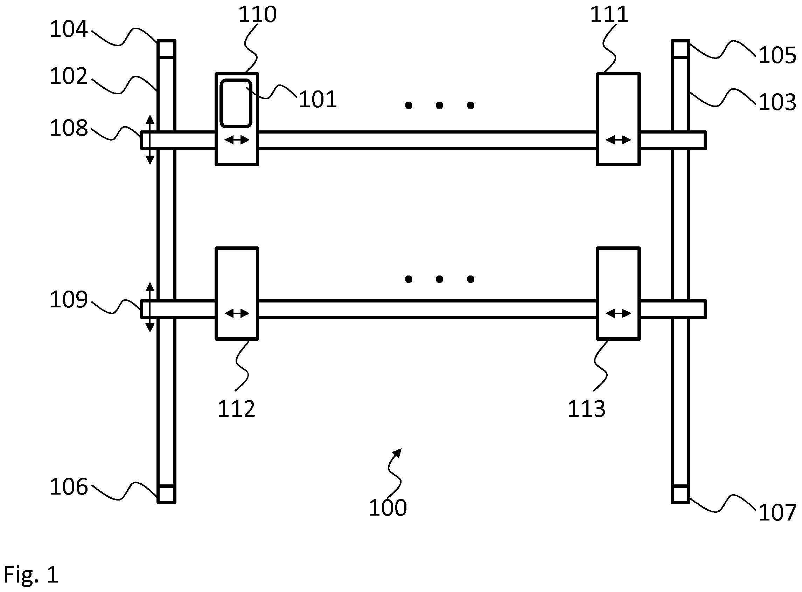

Fig. 1 shows a schematic view of a test device carrier rack 100 in a front view. The test device carrier rack 100 comprises a rack frame (not separately referenced) that is composed of two stands 102, 103, which carry two device carrier beams 108, 109. The stands 102, 103 each comprise a top base 104, 105 and a bottom base 106, 107. The bases 104, 105, 106, 107 serve to hold or shore the test device carrier rack 100 e.g. in a vehicle. It is understood, that the stands 102, 103 may also comprise only the top bases 104, 105, the lower or bottom bases 106, 107 or no base at all. Installed on the device carrier beams 108, 109 are test device fixtures 110, 111, 112, 113. Only two test device fixtures 110, 111, 112, 113 are shown on each device carrier beam 108, 109, but more test device fixtures are hinted at by three dots. The test device fixtures 110, 111, 112, 113 may each carry a test device 101 (only shown for the first test device fixture 110). Although not explicitly shown it is understood that the test device fixtures 110, 111, 112, 113 may e.g. comprise clamp or belt arrangements that may hold the test devices 101.

The test devices 101 may e.g. be smartphones and the measurements may be performed with the internal antennas of the smartphones. Therefore, it is necessary to place the test devices 101 in a position that provides adequate RF characteristics. Especially in vehicles, that form a faraday cage, it is e.g. necessary to place the test devices 101 at the windows that provide an opening in the faraday cage. It is however understood that the test devices 101 may also comprise supplementary test devices, like e.g. RF scanners, compute modules, control modules or the like. Such compute or control modules may comprise a computer program that controls the other test devices to perform the necessary tests and receives the test results or measured data from the other test devices.

The test device carrier rack 100 allows positioning the test devices 101 with the test device fixtures 110, 111, 112, 113. The test device fixtures 110, 111, 112, 113 are movably arranged on the device carrier beams 108, 109 at least movable in a vertical direction (indicated by double headed arrows). This means that the test device carrier rack 100 may e.g. be arranged inside of a vehicle and the test device fixtures 110, 111, 112, 113 may be moved to the ideal position. For example the test device carrier rack 100 may be arranged in the back of a van that has double doors on the back side, each with a window. The test devices 101 should ideally be places inside of the van in front of the windows. With the movable test device fixtures 110, 111, 112, 113 it is possible to position all test devices 101 such that no test device 101 is covered by the central metal section of the doors and all test devices 101 have ideal RF reception behind the windows.

The device carrier beams 108, 109 may e.g. comprise slides and guides which allow moving the test device fixtures 110, 111, 112, 113. Slides or guides may e.g. be provided as recesses in the profiles of the device carrier beams 108, 109. The device carrier beams 108, 109 may e.g. be provided as aluminum profiles that have built-in recesses. The test device fixtures 110, 111, 112, 113 may be guided in the recesses via bolts with heads that fit into the recesses and may be retracted or tensioned to fix the respective test device fixture 110, 111, 112, 113.

As an option the device carrier beams 108, 109 may be slidably attached to the stands 102, 103. This option allows vertically positioning the test device fixtures 110, 111, 112, 113 in addition to the horizontal positioning as described above.

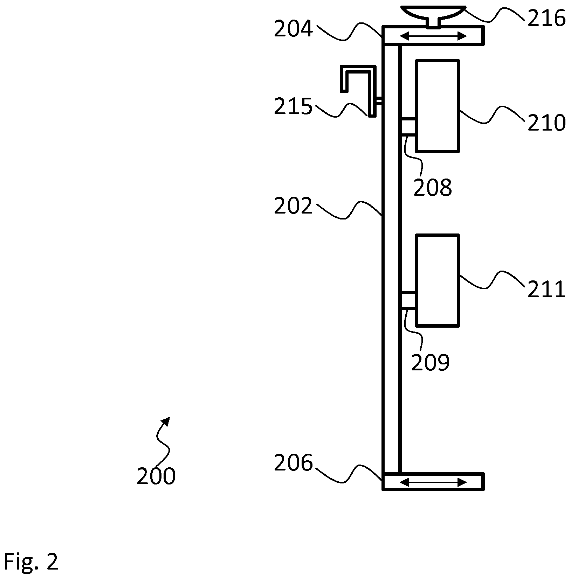

Fig. 2 shows a schematic view of another test device carrier rack 200 in a side view. The test device carrier rack 200 also comprises stands 202 of which only one can be seen in the side view. In addition the test device carrier rack 200 comprises device carrier beams 208, 209 with respective test device fixtures 210, 211.

The stands 202 also comprise top bases 204 and bottom bases 206. It can be seen that the top bases 204 and bottom bases 206 extend orthogonally from the stands 202. Further, it is hinted at by double-headed arrows that the top bases 204 and bottom bases 206 may be moved horizontally for adapting the position of the stands 202 relative to the top bases 204 and bottom bases 206.

The test device carrier rack 200 in addition to the elements of the test device carrier rack 100 comprises exemplary installation means 215, 216 that may serve to fix the test device carrier rack 200 in its operating position, e.g. in a vehicle. It is understood, that the installation means 215, 216 are just exemplary in nature and in number and that any other type or number of installation means 215, 216 is possible at any adequate position of the test device carrier rack 200.

The hook 215 may e.g. be used to fix the test device carrier rack 200 at the windows of a vehicle. The hook 215 may e.g. be put over the window edge and the window may be closed. The suction cup 216 may be used to fix the test device carrier rack 200 to smooth surfaces e.g. painted metal sections of the vehicle interior. Other types of installation means may e.g. comprise plates with holes, clamps, plates with adhesive tape or the like.

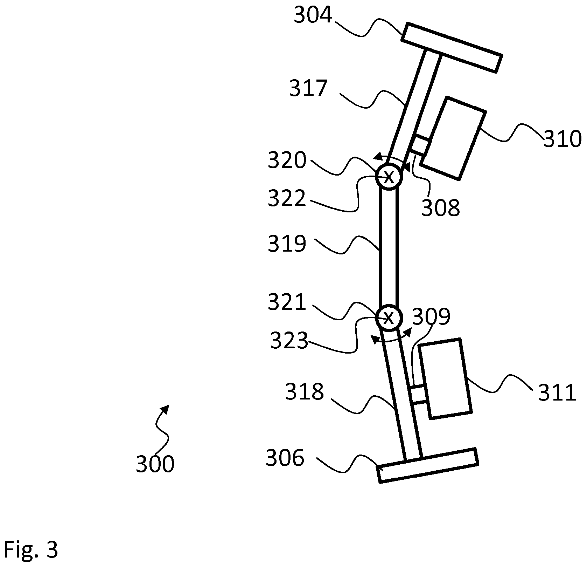

Fig. 3 shows a schematic view of another test device carrier rack 300 in a side view. The test device carrier rack 300 also comprises stands (not separately referenced) of which only one can be seen in the side view. In addition the test device carrier rack 300 comprises device carrier beams 308, 309 with respective test device fixtures 310, 311. The stands also comprise top bases 304 and bottom bases 306. In contrast to the top bases 204 and bottom bases 206, the stands couple to the top bases 304 and bottom bases 306 at about one third of the length of the top bases 304 and bottom bases 306.

The stands of the test device carrier rack 300 each comprise an upper leg 317, a middle section 319 and a lower leg 318. The upper leg 317 is coupled to the middle section 319 via a tiltable hinge 320 and the middle section 319 is coupled to the lower leg 318 via another tiltable hinge 321. The tiltable hinges 320, 321 allow tilting the upper leg 317 the middle section 319 and the lower leg 318 relative to each other around vertical axis 322, 323.

With the tiltable hinges 320, 321 the test device carrier rack 300 may be adapted to different geometries e.g. of vehicles that accommodate the test device carrier rack 300. The tiltable hinges 320, 321 may also comprise fixation means to fix the tiltable hinges 320, 321 in a set position.

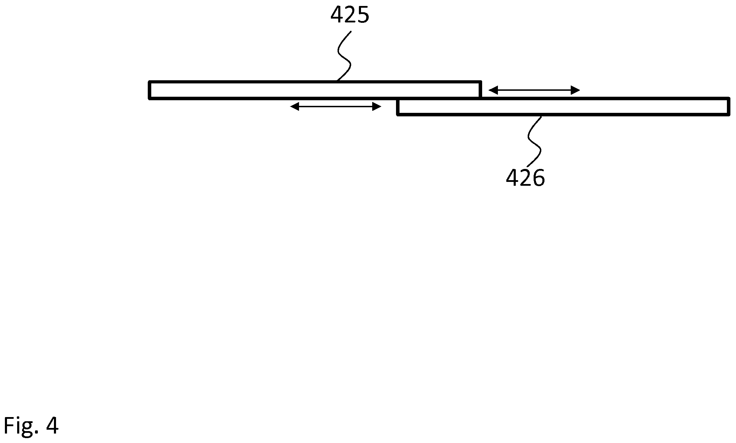

Fig. 4 shows a schematic view of an embodiment of an extendable beam. The extendable beam of Fig. 4 comprises a first beam section 425 and a second beam section 426. The first beam section 425 and the second beam section 426 are slidably coupled to each other such that they may be moved vertically to each other.

The extendable beam of Fig. 4 may e.g. be used as device carrier beam. Such an arrangement allows modifying the width of the test device carrier rack and further adapting the test device carrier rack to the mounting space.

In addition, any other structural element of the test device carrier racks presented here may also comprise the extendable beam. For example the stands of the test device carrier rack 100, the test device carrier rack 200 and the test device carrier rack 300 may be extendable as well as the upper and lower legs 317, 318.

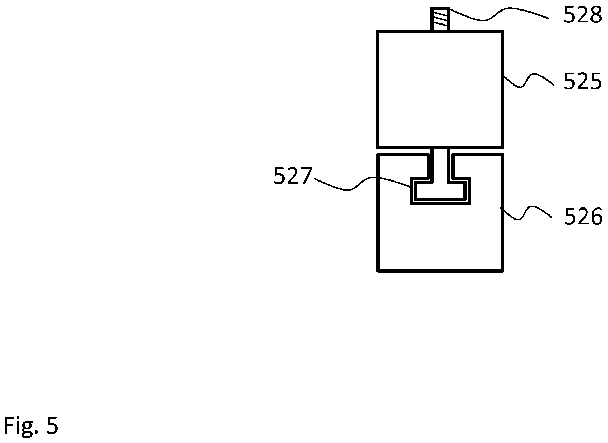

Fig. 5 shows a cross sectional view of the extendable beam of Fig. 4. In the cross section it can be seen that the second beam section 526 comprises a recess 527 and that the first beam section 525 carries a bolt 528 with a head that fits into the recess 527. For fixing the first beam section 525 and the second beam section 526 in position it is sufficient to retract or tension the bolt 528. This can e.g. be done with a winged nut, a (mold-injected) lever with an integrated nut or a lever that pulls on the bolt 528 when actuated.

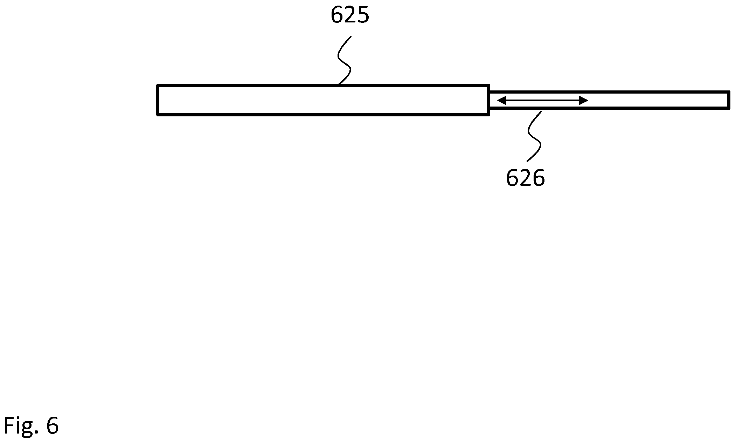

Fig. 6 shows a schematic view of another embodiment of an extendable beam. The extendable beam of Fig. 6 also comprises a first beam section 625 and a second beam section 626. The first beam section 625 is larger in diameter than the second beam section 626 and the second beam section 626 is inserted into the first beam section 625. The two beam sections 625, 626 therefore form a telescopic extendable beam. It is understood, that any other mechanical arrangement may also be provided that allows extending or retracting a beam. Further, electric motors may be used to extend or retract such beams.

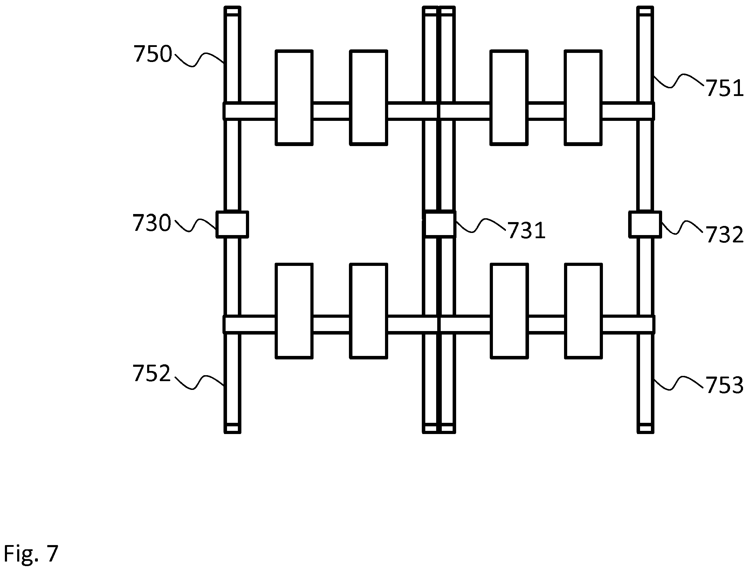

Fig. 7 shows a schematic view of an embodiment of coupled test device carrier racks 750, 751, 752, 753. The coupled test device carrier racks 750, 751, 752, 753 may be any type of test device carrier rack as described herein. For sake of clarity, the single elements of the test device carrier racks 750, 751, 752, 753 are not referenced separately.

Fig. 7 shows that the single test device carrier racks 750, 751, 752, 753 may serve as building modules of a larger test device carrier rack. The single test device carrier racks 750, 751, 752, 753 may be coupled to each other with the help of coupling devices 730, 731, 732. The coupling devices 730, 731, 732 may be any type of mechanical device that allows coupling two or more test device carrier racks 750, 751, 752, 753 to each other. The coupling device 731 e.g. couples all four test device carrier racks 750, 751, 752, 753, while coupling devices 730, 732 each only couple two of the test device carrier racks 750, 751, 752, 753.

The coupling devices 730, 731, 732 may e.g. comprise clamps, brackets, clips, screws or the like.

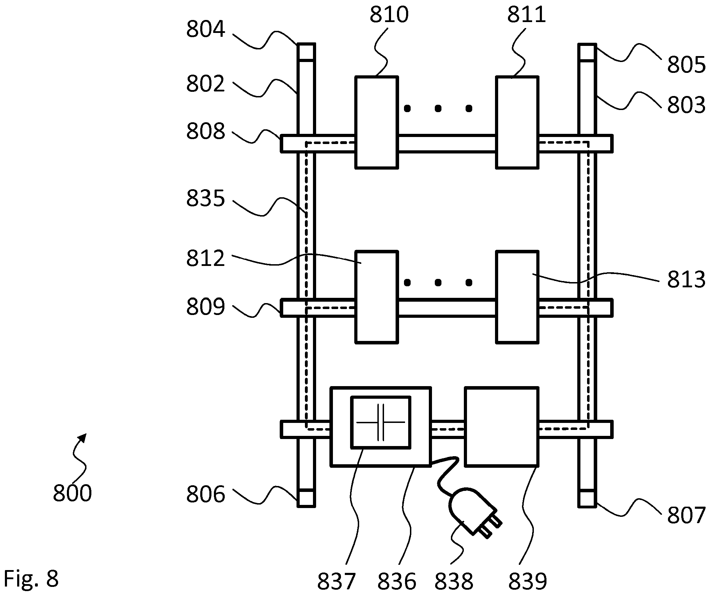

Fig. 8 shows a schematic view of another test device carrier rack 800 that is based on the test device carrier rack 100. It is however understood that the features described below, especially the cable harness 835, the power supply device 836 and the compute module 839 may be combined with any one of the above described test device carrier rack 200, test device carrier rack 300, and test device carrier racks 750, 751, 752, 753.

The test device carrier rack 800 comprises a rack frame (not separately referenced) that is composed of two stands 802, 803, which carry two device carrier beams 808, 809. The stands 802, 803 each comprise a top base 804, 805 and a bottom base 806, 807. Installed on the device carrier beams 808, 809 are test device fixtures 810, 811, 812, 813. Only two test device fixtures 810, 811, 812, 813 are shown on each device carrier beam 808, 809, but more test device fixtures are hinted at by three dots.

As already indicated with regard to Fig. 1, the test devices may not only comprise measurement devices. Instead, supporting test devices are possible. As an example the test device carrier rack 800 comprises two such supporting test devices.

One is the power supply device 836. The power supply device 836 comprises an energy storage device 837 (one is shown, multiple are possible) and a power plug 838. The energy storage device 837 may e.g. be a battery or any other adequate storage device. The energy storage device 837 may e.g. be charged from a mains power outlet via power plug 838. The power plug 838 may also be adapted to couple to a power outlet in a vehicle, like e.g. a 12 V cigarette lighter outlet. The power supply device 836 may supply the test devices in the test device carrier rack 800 with electrical power while a test is performed. The power supply device 836 may therefore extend the autonomous life of the test arrangement installed on the test device carrier rack 800.

Another supplementary test device that is installed on the test device carrier rack 800 is the compute module 839. The compute module 839 may be a controller for a test arrangement installed on the test device carrier rack 800. It is understood, that further compute modules may be installed, wherein single compute modules 839 may handle a specific group of test devices. As an alternative or in addition, compute modules with different functions may be provided. For example one compute module may receive measurement data from the other test devices, another compute module may perform some analysis functions on the measurement data and another compute module may store the measurement data. The compute modules 839 may be coupled to each other via a data network, like an Ethernet network or a data bus.

The power supply device 836 and the compute module 839 may e.g. be coupled to the test device fixtures 810, 811, 812, 813 via a dedicated cabling, that may e.g. be fixed to the test device carrier rack 800 via straps.

However, the test device carrier rack 800 comprises a dedicated cable harness 835 that couples the power supply device 836 and the compute module 839 to the test device fixtures 810, 811, 812, 813. The cable harness 835 may e.g. comprise cables that are provided on or inside of the structural elements of the test device carrier rack 800, like the stands 802, 803 and the device carrier beams 808, 809. The cable harness 835 may at least in part also comprise bus bars that may e.g. be fixed to or integrated into the structural elements of the test device carrier rack 800.

The cable harness 835 allows contacting test devices in the test device fixtures 810, 811, 812, 813 without the need for additional cabling and therefore greatly reduces the installation effort for test arrangements in the test device carrier rack 800.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

In the foregoing detailed description, various features are grouped together in one or more examples or examples for the purpose of streamlining the disclosure. It is understood that the above description is intended to be illustrative, and not restrictive. It is intended to cover all alternatives, modifications and equivalents as may be included within the scope of the invention. Many other examples will be apparent to one skilled in the art upon reviewing the above specification.

Specific nomenclature used in the foregoing specification is used to provide a thorough understanding of the invention. However, it will be apparent to one skilled in the art in light of the specification provided herein that the specific details are not required in order to practice the invention. Thus, the foregoing descriptions of specific embodiments of the present invention are presented for purposes of illustration and description. They are not intended to be exhaustive or to limit the invention to the precise forms disclosed; obviously many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated. Throughout the specification, the terms "including" and "in which" are used as the plain-English equivalents of the respective terms "comprising" and "wherein," respectively. Moreover, the terms "first," "second," and "third," etc., are used merely as labels, and are not intended to impose numerical requirements on or to establish a certain ranking of importance of their objects.

### List of reference signs

- 100, 200, 300, 750, 751, 752, 753: test device carrier rack
- 800: test device carrier rack
- 101: test device
- 102, 103,202,802,803: stand
- 104, 105, 204, 304, 804, 805: top base
- 106, 107, 206, 306, 806, 807: bottom base
- 108, 109, 208, 209, 308, 309: device carrier beam
- 808, 809: device carrier beam
- 110, 111, 112, 113, 210, 211: test device fixture
- 310, 311, 810, 811, 812, 813: test device fixture
- 215, 216: installation means
- 317: upper leg
- 318: lower leg
- 319: middle section
- 320, 321: tiltable hinge
- 322, 323: vertical axis

- 425, 426, 525, 526, 625, 626: beam section
- 527: recess
- 528: bolt

- 730, 731, 732: coupling device

- 835: cable harness
- 836: power supply device
- 837: energy storage device
- 838: plug
- 839: compute module

## Claims

1. Test device carrier rack (100, 200, 300, 750, 751, 752, 753, 800) for carrying test devices (101), the test device carrier rack (100, 200, 300, 750, 751, 752, 753, 800) comprising:
a rack frame, the rack frame comprising a number of stands (102, 103, 202, 802, 803) and a number of device carrier beams (108, 109, 208, 209, 308, 309, 808, 809) that are coupled to the stand (102, 103, 202, 802, 803), and
a number of test device fixtures (110, 111, 112, 113, 210, 211, 310, 311, 810, 811, 812, 813) movably arranged on the device carrier beams (108, 109, 208, 209, 308, 309, 808, 809) and configured to carry the test devices (101), wherein the test device fixtures (110, 111, 112, 113, 210, 211, 310, 311, 810, 811, 812, 813) are each attached to the device carrier beams (108, 109, 208, 209, 308, 309, 808, 809) via a slidable and/or releasable fixture.

2. Test device carrier rack (100, 200, 300, 750, 751, 752, 753, 800) according to claim 1, wherein the stands (102, 103, 202, 802, 803) comprise at least one lower leg (318) with a bottom base (106, 107, 206, 306, 806, 807) attached the lower leg (318); and/or
wherein the stands (102, 103, 202, 802, 803) comprise at least one upper leg (317) with a top base (104, 105, 204, 304, 804, 805) attached to the upper leg (317).

3. Test device carrier rack (100, 200, 300, 750, 751, 752, 753, 800) according to claim 2, wherein the at least one lower leg (318) and/or the at least on upper leg (317) is vertically extendable; and/or
wherein the device carrier beams (108, 109, 208, 209, 308, 309, 808, 809) are horizontally extendable.

4. Test device carrier rack (100, 200, 300, 750, 751, 752, 753, 800) according to any one of the preceding claims, wherein the device carrier beams (108, 109, 208, 209, 308, 309, 808, 809) are horizontally arranged on the rack frame; and/or
wherein the device carrier beams (108, 109, 208, 209, 308, 309, 808, 809) are attached vertically slidable to the rack frame.

5. Test device carrier rack (100, 200, 300, 750, 751, 752, 753, 800) according to any one of the preceding claims, wherein the stands comprise at least one tiltable hinge (320, 321).

6. Test device carrier rack (100, 200, 300, 750, 751, 752, 753, 800) according to any one of the preceding claims, wherein the rack frame and/or the test device fixtures (110, 111, 112, 113, 210, 211, 310, 311, 810, 811, 812, 813) comprise a RF transparent material and/or an optically transparent material.

7. Test device carrier rack (100, 200, 300, 750, 751, 752, 753, 800) according to any one of the preceding claims, wherein the stand (102, 103, 202, 802, 803) comprises installation means (215, 216), wherein the installation means (215, 216) comprise suction cups (216) and/or hooks (215) and/or mounting holes and/or mounting plates.

8. Test device carrier rack (100, 200, 300, 750, 751, 752, 753, 800) according to any one of the preceding claims, comprising optical hiding devices.

9. Test device carrier rack (100, 200, 300, 750, 751, 752, 753, 800) according to any one of the preceding claims, comprising coupling devices (730, 731, 732) for coupling the test device carrier rack (100, 200, 300, 750, 751, 752, 753, 800) with other test device carrier racks (100, 200, 300, 750, 751, 752, 753, 800).

10. Test device carrier rack (100, 200, 300, 750, 751, 752, 753, 800) according to any one of the preceding claims, wherein at least one test device fixtures (110, 111, 112, 113, 210, 211, 310, 311, 810, 811, 812, 813) comprises a device cover with configurable attenuation.

11. Test device carrier rack (100, 200, 300, 750, 751, 752, 753, 800) according to any one of the preceding claims, wherein at least one of the test device fixtures (110, 111, 112, 113, 210, 211, 310, 311, 810, 811, 812, 813) comprises a spring loaded clamping mechanism to clamp one of the test devices; and/or
wherein at least one of the test device fixtures (110, 111, 112, 113, 210, 211, 310, 311, 810, 811, 812, 813) comprises a belt, especially a hook-and-pile fastener belt, for securing one of the test devices (101).

12. Test device carrier rack (100, 200, 300, 750, 751, 752, 753, 800) according to any one of the preceding claims, comprising an integrated cable harness (835) for contacting the test devices (101) in the test device fixtures (110, 111, 112, 113, 210, 211, 310, 311, 810, 811, 812, 813).

13. Test device carrier rack (100, 200, 300, 750, 751, 752, 753, 800) according to any one of the preceding claims, comprising a power supply device (836) for supplying the test devices (101) with electrical energy.

14. Test device carrier rack (100, 200, 300, 750, 751, 752, 753, 800) according to claim 13, wherein the power supply device (836) comprises at least one energy storage device (837).

15. Test device carrier rack (100, 200, 300, 750, 751, 752, 753, 800) according to any one of the preceding claims, comprising a control module and/or a compute module.

## Patentansprüche

1. Trägergestell für Testvorrichtung (100, 200, 300, 750, 751, 752, 753, 800) zum Tragen von Testvorrichtungen (101), wobei das Trägerstell für Testvorrichtung (100, 200, 300, 750, 751, 752, 753, 800) umfasst:
einen Gestellrahmen, wobei der Gestellrahmen eine Anzahl von Ständern (102, 103, 202, 802, 803) und eine Anzahl von Vorrichtungs-Trägerbalken (108, 109, 208, 209, 308, 309, 808, 809) aufweist, die an den Ständer (102, 103, 202, 802, 803) gekoppelt sind, und
eine Anzahl von Befestigungen für Testvorrichtung (110, 111, 112, 113, 210, 211, 310, 311, 810, 811, 812, 813), die beweglich an den Vorrichtungs-Trägerbalken (108, 109, 208, 209, 308, 309, 808, 809) angeordnet sind, und die so konfiguriert sind, dass
die Testvorrichtungen (101) getragen werden, wobei die Befestigungen für Testvorrichtung (110, 111, 112, 113, 210, 211, 310, 311, 810, 811, 812, 813) jeweils über eine verschiebbare und/oder lösbare Befestigung an den Vorrichtungs-Trägerbalken (108, 109, 208, 209, 308, 309, 808, 809) befestigt sind.

2. Trägergestell für Testvorrichtung (100, 200, 300, 750, 751, 752, 753, 800) nach Anspruch 1, wobei die Ständer (102, 103, 202, 802, 803) mindestens ein unteres Bein (318) mit einem unteren Sockel (106, 107, 206, 306, 806, 807) aufweisen, der am unteren Bein (318) befestigt ist; und/oder
wobei die Ständer (102, 103, 202, 802, 803) mindestens ein oberes Bein (317) mit einem oberen Sockel (104, 105, 204, 304, 804, 805) aufweisen, der am oberen Bein (317) befestigt ist.

3. Trägergestell für Testvorrichtung (100, 200, 300, 750, 751, 752, 753, 800) nach Anspruch 2, wobei mindestens ein unteres Bein (318) und/oder mindestens ein oberes Bein (317) vertikal ausfahrbar ist/sind; und/oder
wobei die Vorrichtungs-Trägerbalken (108, 109, 208, 209, 308, 309, 808, 809) horizontal ausfahrbar sind.

4. Trägergestell für Testvorrichtung (100, 200, 300, 750, 751, 752, 753, 800) nach einem der vorstehenden Ansprüche, wobei die Vorrichtungs-Trägerbalken (108, 109, 208, 209, 308, 309, 808, 809) horizontal am Gestellrahmen angeordnet sind; und/oder
wobei die Vorrichtungs-Trägerbalken (108, 109, 208, 209, 308, 309, 808, 809) vertikal verschiebbar am Gestellrahmen befestigt sind.

5. Trägergestell für Testvorrichtung (100, 200, 300, 750, 751, 752, 753, 800) nach einem der vorstehenden Ansprüche, wobei die Ständer mindestens einen Kippbeschlag (320, 321) aufweisen.

6. Trägergestell für Testvorrichtung (100, 200, 300, 750, 751, 752, 753, 800) nach einem der vorstehenden Ansprüche, wobei der Gestellrahmen und/oder die Befestigungen für Testvorrichtung (110, 111, 112, 113, 210, 211, 310, 311, 810, 811, 812, 813) ein transparentes und/oder optisch transparentes RF-Material aufweisen.

7. Trägergestell für Testvorrichtung (100, 200, 300, 750, 751, 752, 753, 800) nach einem der vorstehenden Ansprüche, wobei der Ständer (102, 103, 202, 802, 803) Installationsmittel (215, 216) umfasst, wobei die Installationsmittel (215, 216) Saugnäpfe (216) und/oder Haken (215) und/oder Montagelöcher und/oder Montageplatten aufweisen.

8. Trägergestell für Testvorrichtung (100, 200, 300, 750, 751, 752, 753, 800) nach einem der vorstehenden Ansprüche, wobei das Trägergestell optische Verbergungsmittel aufweist.

9. Trägergestell für Testvorrichtung (100, 200, 300, 750, 751, 752, 753, 800) nach einem der vorstehenden Ansprüche, wobei das Trägergestell Kopplungsvorrichtungen (730, 731, 732) zum Ankoppeln des Trägergestells für Testvorrichtung (100, 200, 300, 750, 751, 752, 753, 800) an andere Trägergestelle für Testvorrichtung (100, 200, 300, 750, 751, 752, 753, 800) umfasst.

10. Trägergestell für Testvorrichtung (100, 200, 300, 750, 751, 752, 753, 800) nach einem der vorstehenden Ansprüche, wobei mindestens eine der Befestigungen für Testvorrichtung (110, 111, 112, 113, 210, 211, 310, 311, 810, 811, 812, 813) eine Vorrichtungsabdeckung mit konfigurierbarer Dämpfung aufweist.

11. Trägergestell für Testvorrichtung (100, 200, 300, 750, 751, 752, 753, 800) nach einem der vorstehenden Ansprüche, wobei mindestens eine der Befestigungen für Testvorrichtung (110, 111, 112, 113, 210, 211, 310, 311, 810, 811, 812, 813) einen federbelasteten Klemmmechanismus zum Festklemmen einer der Testvorrichtungen aufweist; und/oder
wobei mindestens eine der Befestigungen für Testvorrichtung (110, 111, 112, 113, 210, 211, 310, 311, 810, 811, 812, 813) einen Riemen, insbesondere einen Klettverschluss-Befestigungsriemen, zum Sichern einer der Testvorrichtungen (101) umfasst.

12. Trägergestell für Testvorrichtung (100, 200, 300, 750, 751, 752, 753, 800) nach einem der vorstehenden Ansprüche, wobei das Trägergestell einen integrierten Kabelstrang (835) zum Inkontaktbringen der Testvorrichtungen (101) in den Befestigungen für Testvorrichtung (110, 111, 112, 113, 210, 211, 310, 311, 810, 811, 812, 813) aufweist.

13. Trägergestell für Testvorrichtung (100, 200, 300, 750, 751, 752, 753, 800) nach einem der vorstehenden Ansprüche, wobei das Trägergestell eine Energieversorgungseinrichtung (836) zum Versorgen der Testvorrichtungen (101) mit elektrischer Energie aufweist.

14. Trägergestell für Testvorrichtung (100, 200, 300, 750, 751, 752, 753, 800) nach Anspruch 13, wobei die Energieversorgungseinrichtung (836) mindestens eine Energiespeichervorrichtung (837) aufweist.

15. Trägergestell für Testvorrichtung (100, 200, 300, 750, 751, 752, 753, 800) nach einem der vorstehenden Ansprüche, wobei das Trägergestell ein Steuermodul und/oder ein Computermodul aufweist.

## Revendications

1. Support porteur de dispositif de test (100, 200, 300, 750, 751, 752, 753, 800) pour porter des dispositifs de test (101), le support porteur de dispositif de test (100, 200, 300, 750, 751, 752, 753, 800) comprenant :
un bâti de support, le bâti de support comprenant un certain nombre de socles (102, 103, 202, 802, 803) et un certain nombre de poutres porteuses de dispositif (108, 109, 208, 209, 308, 309, 808, 809) qui sont couplées au socle (102, 103, 202, 802, 803) ; et
un certain nombre de fixations de dispositif de test (110, 111, 112, 113, 210, 211, 310, 311, 810, 811, 812, 813) agencées de manière mobile sur les poutres porteuses de dispositif (108, 109, 208, 209, 308, 309, 808, 809) et configurées pour porter les dispositifs de test (101), dans lequel les fixations de dispositif de test (110, 111, 112, 113, 210, 211, 310, 311, 810, 811, 812, 813) sont chacune fixées aux poutres porteuses de dispositif (108, 109, 208, 209, 308, 309, 808, 809) via une fixation coulissante et/ou amovible.

2. Support porteur de dispositif de test (100, 200, 300, 750, 751, 752, 753, 800) selon la revendication 1, dans lequel les socles (102, 103, 202, 802, 803) comprennent au moins une patte inférieure (318) avec une base inférieure (106, 107, 206, 306, 806, 807) fixée à la patte inférieure (318) ; et/ou
dans lequel les socles (102, 103, 202, 802, 803) comprennent au moins une patte supérieure (317) avec une base supérieure (104, 105, 204, 304, 804, 805) fixée à la patte supérieure (317).

3. Support porteur de dispositif de test (100, 200, 300, 750, 751, 752, 753, 800) selon la revendication 2, dans lequel la au moins une patte inférieure (318) et/ou la au moins une patte supérieure (317) est verticalement extensible ; et/ou
dans lequel les poutres porteuses de dispositif (108, 109, 208, 209, 308, 309, 808, 809) sont horizontalement extensibles.

4. Support porteur de dispositif de test (100, 200, 300, 750, 751, 752, 753, 800) selon l'une quelconque des revendications précédentes, dans lequel les poutres porteuses de dispositif (108, 109, 208, 209, 308, 309, 808, 809) sont agencées horizontalement sur le bâti de support ; et/ou
dans lequel les poutres porteuses de dispositif (108, 109, 208, 209, 308, 309, 808, 809) sont fixées de manière verticalement coulissante sur le bâti de support.

5. Support porteur de dispositif de test (100, 200, 300, 750, 751, 752, 753, 800) selon l'une quelconque des revendications précédentes, dans lequel les socles comprennent au moins une charnière inclinable (320, 321).

6. Support porteur de dispositif de test (100, 200, 300, 750, 751, 752, 753, 800) selon l'une quelconque des revendications précédentes, dans lequel le bâti de support et/ou les fixations de dispositif de test (110, 111, 112, 113, 210, 211, 310, 311, 810, 811, 812, 813) comprennent un matériau transparent aux RF et/ou un matériau transparent du point de vue optique.

7. Support porteur de dispositif de test (100, 200, 300, 750, 751, 752, 753, 800) selon l'une quelconque des revendications précédentes, dans lequel le socle (102, 103, 202, 802, 803) comprend des moyens d'installation (215, 216), dans lequel les moyens d'installation (215, 216) comprennent des ventouses (216) et/ou des crochets (215) et/ou des trous de montage et/ou des plaques de montage.

8. Support porteur de dispositif de test (100, 200, 300, 750, 751, 752, 753, 800) selon l'une quelconque des revendications précédentes, comprenant des dispositifs de masquage optique.

9. Support porteur de dispositif de test (100, 200, 300, 750, 751, 752, 753, 800) selon l'une quelconque des revendications précédentes, comprenant des dispositifs de couplage (730, 731, 732) pour coupler le support porteur de dispositif de test (100, 200, 300, 750, 751, 752, 753, 800) avec d'autres supports porteurs de dispositif de test (100, 200, 300, 750, 751, 752, 753, 800).

10. Support porteur de dispositif de test (100, 200, 300, 750, 751, 752, 753, 800) selon l'une quelconque des revendications précédentes, dans lequel la au moins une fixation de dispositif de test (110, 111, 112, 113, 210, 211, 310, 311, 810, 811, 812, 813) comprend un couvercle de dispositif avec une atténuation configurable.

11. Support porteur de dispositif de test (100, 200, 300, 750, 751, 752, 753, 800) selon l'une quelconque des revendications précédentes, dans lequel au moins l'une des fixations de dispositif de test (110, 111, 112, 113, 210, 211, 310, 311, 810, 811, 812, 813) comprend un mécanisme de serrage à ressort pour serrer l'un des dispositifs de test ; et/ou
dans lequel au moins l'une des fixations de dispositif de test (110, 111, 112, 113, 210, 211, 310, 311, 810, 811, 812, 813) comprend une courroie, en particulier une courroie de fixation à boucles et crochets, pour fixer l'un des dispositifs de test (101).

12. Support porteur de dispositif de test (100, 200, 300, 750, 751, 752, 753, 800) selon l'une quelconque des revendications précédentes, comprenant un faisceau de câbles intégré (835) pour être en contact avec les dispositifs de test (101) dans les fixations de dispositif de test (110, 111, 112, 113, 210, 211, 310, 311, 810, 811, 812, 813).

13. Support porteur de dispositif de test (100, 200, 300, 750, 751, 752, 753, 800) selon l'une quelconque des revendications précédentes, comprenant un dispositif d'alimentation d'énergie (836) pour alimenter les dispositifs de test (101) avec de l'énergie électrique.

14. Support porteur de dispositif de test (100, 200, 300, 750, 751, 752, 753, 800) selon la revendication 13, dans lequel le dispositif d'alimentation d'énergie (836) comprend au moins un dispositif de stockage d'énergie (837).

15. Support porteur de dispositif de test (100, 200, 300, 750, 751, 752, 753, 800) selon l'une quelconque des revendications précédentes, comprenant un module de commande et/ou un module de calcul.
